# FASCICULE DE BREVET EUROPEEN

(11) **EP 2 151 923 B1**
(45) Date de publication et mention de la délivrance du brevet: **09.03.2011**
(21) Numéro de dépôt: 09164720.6
(22) Date de dépôt: 07.07.2009
(51) Int. Cl.: H03J 1/00, G01S 5/04

(54) **RECEPTEUR A BALAYAGE RAPIDE POUR LA SURVEILLANCE DU SPECTRE ELECTROMAGNETIQUE ET PROCEDE POUR LA MISE EN OEUVRE DU RECEPTEUR**
Empfänger mit Schnellabtasung zur Überwachung des elektromagnetischen Spektrums und Verfahren zur Inbetriebnahme dieses Empfängers
Quick-scanning receiver for supervising the electromagnetic spectrum and method for implementing the receiver

(30) Priorité: 08.08.2008 FR 0804536
(43) Date de publication de la demande: 10.02.2010
(73) Titulaire: THALES, 92200 Neuilly-sur-Seine (FR)
(72) Inventeur: BOUCARD, Hubert, 75009, PARIS (FR); JOURDAN, François, 78470, Saint Remy lès Chevreuse (FR)
(74) Mandataire: Lucas, Laurent Jacques

(56) Documents cités:
- US-A- 4 639 733
- US-A1- 2004 113 839
- US-A1- 2006 227 050

## Description

La présente invention concerne une architecture de récepteur radioélectrique destiné à la surveillance du spectre électromagnétique dans le domaine des hyperfréquences.

Les récepteurs radioélectriques destinés à la surveillance du spectre électromagnétique doivent, en général, effectuer une détection de signaux émis par un émetteur électromagnétique, notamment des impulsions radar, dans une bande de fréquences totale bien plus grande que la bande instantanée qu'ils sont capables d'analyser. Par exemple, la bande totale à surveiller peut être de quelques 10 GHz alors que dans un récepteur de type superhétérodyne la bande de fréquence instantanée pouvant être analysée ne dépasse pas quelques centaines de MHz.

De la même façon que pour la surveillance de la bande de fréquence totale se pose le problème d'une surveillance de l'espace sur 360° pour détecter la direction du signal reçu. Un récepteur connecté à une antenne à grand gain, ne peut détecter instantanément un signal reçu que dans un secteur angulaire de l'espace bien plus faible, habituellement de quelques degrés.

Le récepteur doit détecter, entre d'autres paramètres caractéristiques du signal reçu, la fréquence du signal mais aussi sa direction et effectuer les mesures prévues sur ce signal. La surveillance par le récepteur de la totalité de la bande dans la couverture angulaire totale de 360° nécessite un temps important et par conséquent la probabilité d'intersection d'un signal émis par l'émetteur à un instant donné peut devenir assez faible, incompatible avec la sécurité de surveillance du spectre souhaitée.

Les récepteurs de l'état de l'art sont construits selon des architectures basées sur une stratégie de balayage lent du domaine fréquentiel et éventuellement angulaire. Par exemple, dans le cas d'une recherche d'émissions d'impulsions radars, le balayage est considéré comme lent dans le sens où la durée d'écoute d'une sous-bande, ou éventuellement d'un secteur angulaire, est de l'ordre d'une à quelque fois la période de répétition attendue des impulsions émises par le radar. Cette période de répétitions d'impulsion, de sigle PRI, est habituellement comprise entre 1µs et 10ms selon la sous-bande. En parallèle avec la détection du signal reçu, les mesures de paramètres primaires du signal sont effectuées sur les impulsions détectées.

Dans ce type de récepteur de l'état de l'art, une fois que la durée d'écoute sur une sous-bande est fixée, la probabilité d'interception d'un signal émis par un émetteur dans un délai fixé (compatible de la durée de passage d'un lobe de l'antenne d'émission si celle-ci est en rotation, ou du temps de réaction souhaité après le début de l'illumination par l'antenne d'émission), dépend principalement de la périodicité de l'écoute sur la sous-bande ou « ReVisit Time » de sigle RVT en langue anglaise, et dès lors que le niveau du signal reçu est supposé détectable ou autrement dit lorsque le signal reçu est supposé au-dessus d'un seuil de détection prédéterminé.

L'avantage d'un tel récepteur de l'état de l'art fonctionnant sur un balayage lent est son insensibilité à la durée de l'impulsion émise par l'émetteur à détecter (radar) mais les inconvénients sont importants. En effet, pour obtenir une bonne probabilité d'interception ou « Probability Of Intercept " de sigle POI en langue anglaise, d'émetteur à faible durée d'éclairement il faut une faible périodicité d'écoute du récepteur dans la sous-bande considérée.

Pour la détection des émetteurs à grande période de répétition des impulsions (PRI), une forte probabilité d'interception (POI) est obtenue seulement au prix d'un important temps d'écoute du récepteur dans la sous-bande considérée.

En pratique ces deux inconvénients : faible périodicité d'écoute et grand temps d'écoute conduisent à établir une stratégie dans ces récepteurs de l'état de l'art devant ignorer des sous-bandes d'écoute (et éventuellement des secteurs angulaires) pour ne garder qu'un nombre restreint des sous-bandes, celles qui contiennent des émetteurs de plus grand intérêt et pour lesquels on souhaite garantir une forte probabilité d'interception. De la même façon des secteurs angulaires peuvent être ignorés au profit de directions angulaires considérées comme les plus intéressantes.

Un récepteur radioélectrique est décrit dans le brevet US2006/0227050 (Vaughn, Jr).

Il est décrit un système pour détecter la direction du signal reçu, dans lequel un nombre de bandes adjacentes est séquentiellement mesuré et les résultats de mesure de chaque bande sont traité par un système FFT pour déterminer la phase et l'amplitude de chaque signal dans la bande.

Pour pallier les inconvénients des récepteurs de veille du spectre électromagnétique, l'invention propose un récepteur radioélectrique de surveillance à balayage rapide du spectre électromagnétique dans une bande de fréquences comportant plusieurs sous-bandes de fréquences,
le récepteur de surveillance comporte :
- au moins une voie de détection rapide comportant un récepteur à balayage rapide RBR de signaux radiofréquences dans au moins une des sous-bandes de fréquences, le récepteur à balayage rapide RBR étant connecté par une entrée à une antenne de réception radiofréquences de voie rapide et fournissant par une sortie des signaux de réception de voie rapide, un récepteur de mesures partielles RMP générant à partir des signaux de réception de voie rapide des signaux de désignation d'une sous-bande de mesure du signal reçu, de la fréquence et du niveau des signaux détectés par la voie de détection rapide dans la sous-bande de fréquences écoutée (ou surveillée),
- p voies de mesures des signaux radiofréquences reçus, p étant un nombre égal ou supérieur à 1, chaque voie de mesures étant connectée par une entrée de voie de mesures par l'intermédiaire d'une ligne à retard LAR à une antenne de réception radiofréquences de mesures destinée à recevoir des signaux à détecter dans un secteur angulaire de l'espace, chaque voie de mesures comportant n canaux de réception, n étant un nombre égal ou supérieur à 1, chacun des canaux de réception fournissant des signaux de réception dans la sous-bande de mesure déterminée par les signaux de désignation générés par la voie de détection rapide, un récepteur RMC par voie de mesures fournissant, à partir des signaux de réception en sortie des n canaux de réception de la voie de mesures considérée, des mesures complètes du signal radiofréquence reçu par le récepteur de surveillance.

Avantageusement, le récepteur à balayage rapide RBR comporte un convertisseur RF/FI de la fréquence d'entrée RF en fréquence intermédiaire FI fixe, un oscillateur Olr commandé en fréquence attaquant le convertisseur RF/FI pour balayer les sous-bandes de la bande de fréquences de réception de la voie rapide, un filtre FI passe bande PB, de bande passante Br, de la fréquence intermédiaire FI, un convertisseur analogique numérique CAN pour fournir, à une sortie du récepteur à balayage rapide RBR, un signal radiofréquence reçu numérisé.

Dans une réalisation du récepteur de surveillance, chaque canal de réception de chaque voie de mesure comporte un convertisseur RF/FI de la fréquence d'entrée RF de la voie de mesures en fréquence intermédiaire FI fixe, un oscillateur OLm commandé en fréquence attaquant le convertisseur RF/FI du canal de réception pour détecter le signal reçu désigné par la voie de détection rapide, un filtre passe bande PB, de bande passante Bm, en fréquence intermédiaire FI et un convertisseur analogique numérique CAN pour fournir en sortie du canal de réception de la voie de mesures un signal radiofréquence reçu numérisé.

Dans une réalisation du récepteur de surveillance, les signaux de désignation générés par le récepteur à balayage rapide fournissent à chacun des canaux de réception une information de largeur de bande de mesure des signaux reçus.

Dans une autre réalisation, la bande passante du filtre FI de chaque canal de réception est programmable par son respectif signal de désignation généré par le récepteur de mesures partielles RMP de la voie de détection rapide.

Dans une autre réalisation la bande passante du filtre passe bande PB du récepteur RBR de la voie de détection rapide est de la largeur des sous-bandes de fréquences.

Dans une autre réalisation, les mesures complètes sur le signal radiofréquence reçu comportent au moins la fréquence, le niveau du signal, un temps absolu ou relatif d'arrivée du signal radiofréquence au récepteur.

Dans une autre réalisation, lorsque le signal reçu est une suite d'impulsions radar, les mesures complètes sur l'impulsion émise comportent au moins la date d'arrivée du front montant et celle du front descendant, la durée et les caractéristiques de la modulation.

Dans une autre réalisation, le temps de balayage de la bande de fréquence à surveiller étant formée par une suite de périodes d'écoute, une durée d'écoute (Te) de la voie de détection rapide est de l'ordre de grandeur de la plus courte durée d'impulsion émise par un émetteur, soit inférieure ou égale à 100ns.

Dans une autre réalisation, la bande passante (Bm) du filtre passe bande PB des canaux de réception des voies de mesures est inférieure à la bande passante (Br) du récepteur RBR de la voie rapide (Bm<Br).

L'invention concerne aussi un procédé de surveillance du spectre électromagnétique dans une bande de fréquences comportant plusieurs sous- bandes de fréquences par un récepteur radioélectrique selon l'invention,
le récepteur de surveillance comportant :
- au moins une voie de détection rapide comportant un récepteur à balayage rapide RBR de signaux radiofréquences dans au moins une des sous-bandes de fréquences, le récepteur à balayage rapide RBR étant connecté par une entrée à une antenne de réception radiofréquences de voie rapide et fournissant par une sortie des signaux de réception de voie rapide, un récepteur de mesures partielles RMP générant à partir des signaux de réception de voie rapide des signaux de désignation d'une sous-bande de mesure du signal reçu, de la fréquence et du niveau des signaux détectés par la voie de détection rapide dans la sous-bande de fréquences écoutée (ou surveillée),
- p voies de mesures des signaux radiofréquences reçus, p étant un nombre égal ou supérieur à 1, chaque voie de mesures étant connectée par une entrée de voie de mesures par l'intermédiaire d'une ligne à retard LAR à une antenne de réception radiofréquences de mesures destinée à recevoir des signaux à détecter dans un secteur angulaire de l'espace, chaque voie de mesures comportant n canaux de réception, n étant un nombre égal ou supérieur à 1, chacun des canaux de réception fournissant des signaux de réception dans la sous-bande de mesure déterminée par les signaux de désignation générés par la voie de détection rapide, un récepteur RMC par voie de mesures fournissant, à partir des signaux de réception en sortie des n canaux de réception de la voie de mesures considérée des mesures complètes du signal radiofréquence reçu par le récepteur de surveillance,
caractérisé en ce qu'il consiste :
- à effectuer, par la voie de détection rapide, un balayage rapide en fréquence d'au moins une sous-bande de fréquences de la bande de fréquences à surveiller, une détection rapide des signaux radiofréquences reçus dans la sous-bande de fréquences considérée, la fourniture des signaux de désignation pour piloter chaque voie de mesures,
- à commander en fréquence, par les signaux de désignation, la fréquence de réception des canaux de réception des voies de mesures,
- à effectuer des mesures complètes des signaux reçus par les voies de mesures en sortie des canaux de réception par les récepteurs de mesures complètes RMC.

Dans une réalisation du procédé, l'acquisition du signal radiofréquence reçu de type impulsionnel se fait en au moins deux temps :
- dans un premier temps, la voie de détection rapide avertit de la présence d'un signal radiofréquence en effectuant un balayage rapide de la bande de fréquences à surveiller par sélection de la sous-bande de fréquences, éventuellement par sélection de l'angle de surveillance et par sélection du niveau du signal, puis détection du signal dans la sous-bande de surveillance (ou de veille),
- dans un deuxième temps, des mesures complètes du signal radiofréquence reçu sont effectuées avec précision par les voies de mesures pilotées par la voie de détection rapide.

Dans une autre réalisation du procédé, les mesures effectuées par les récepteurs RMC de mesures compètes sont habituellement, la mesure précise de la fréquence, le niveau du signal reçu, le temps absolu ou relatif d'apparition de l'impulsion, la durée de l'impulsion, les caractéristiques des modulations dans l'impulsion (modulation intra pulse).

Dans une autre réalisation du procédé, le signal reçu étant une impulsion, la ligne à retard LAR de la voie de mesures retarde ladite impulsion reçue pour effectuer les mesures complètes sur la même impulsion détectée par la voie de détection rapide.

Dans une autre réalisation du procédé, le temps de balayage par la voie de détection rapide de la bande de fréquences à surveiller est formé par une suite de périodes d'écoute (ou durée d'écoute) dans une sous-bande de la bande de fréquences à surveiller.

Dans une autre réalisation du procédé, la période d'écoute (ou durée d'écoute) est inférieure ou égale à 100ns.

Dans une autre réalisation du procédé, les p voies de mesures assurent la détection, par goniométrie, de la direction du signal radiofréquence reçu par le récepteur de surveillance selon l'invention.

La solution apportée par la présente invention construit sa stratégie de balayage en fréquence sur le principe d'une trame à balayage rapide du domaine fréquentiel et éventuellement angulaire.

Le balayage est rapide au sens ou la durée d'écoute sur une sous-bande de fréquences de la bande de fréquences à surveiller est la plus courte possible sans compromettre la performance de sensibilité du récepteur et donc du même ordre de grandeur que la plus petite durée d'analyse spectrale des récepteurs de l'état de l'art à balayage lent.

L'invention sera mieux comprise à l'aide d'un exemple d'architecture d'un récepteur selon l'invention et un procédé de mise en oeuvre du récepteur en référence aux figures indexées dans lesquelles :
- la figure 1 montre une structure générale d'un récepteur de surveillance à balayage rapide selon l'invention ;
- la figure 2 montre un schéma synoptique de principe d'un procédé de mise en oeuvre du récepteur de la figure 1 et ;
- les figures 3a, 3b et 3c montrent des diagrammes de détection d'impulsions radar par une trame de veille du récepteur de la figure 1.

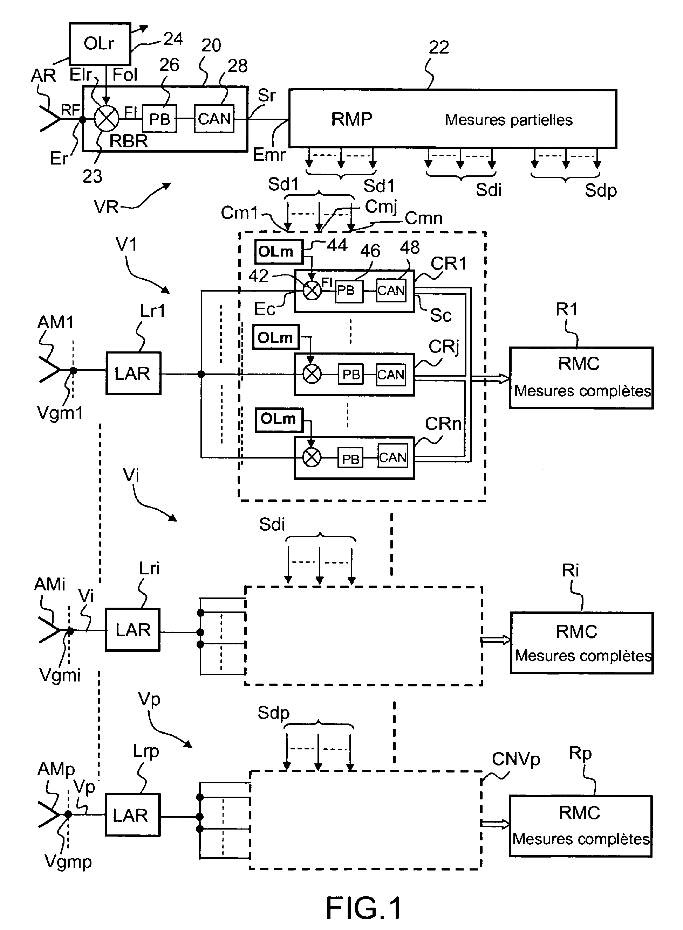

La figure 1 montre une structure générale d'un récepteur de surveillance à balayage rapide selon l'invention destiné à la surveillance du spectre électromagnétique dans une bande hyperfréquences de surveillance. La bande totale de fréquences est aussi partagée en sous-bandes de fréquences.

Ce type de récepteur pour la surveillance du spectre électromagnétique permet la détection de signaux radioélectriques émis par des émetteurs non destinés à la transmission d'informations ou de type désigné par émetteur « NON COM » en langue anglaise.

Le récepteur de la figure 1 comporte une voie de détection rapide VR ayant essentiellement un récepteur à balayage rapide RBR 20 et un récepteur de mesures partielles RMP 22.

Le récepteur à balayage rapide RBR 20 comprend un convertisseur RF/FI 23 attaqué à une entrée d'oscillateur local Elr par une fréquence locale Fol générée par un oscillateur local OLr 24 agile et commandable en fréquence pour balayer la totalité de la bande de fréquences à surveiller.

Le récepteur à balayage rapide RBR 20 est connecté par une entrée Er du convertisseur RF/FI 23 à une antenne de réception radiofréquences AR de la voie rapide VR. Le convertisseur RF/FI fournit à une sortie une fréquence intermédiaire FI fixe filtrée par un passe bande PB 26 de largeur de bande Br puis appliquée à l'entrée d'un convertisseur analogique digital CAN 28 pour fournir à une sortie Sr du récepteur à balayage rapide RBR le signal radiofréquence reçu numérisé.

Le récepteur de mesures partielles RMP 22 comporte une entrée de mesures Emr recevant le signal radiofréquence reçu numérisé en sortie Sr du récepteur à balayage rapide et fournissant, à partir dudit signal numérisé, un ensemble de signaux de désignation Sd1, Sd2,...Sdi,....Sdp.

Ces signaux de désignation fournissent notamment, une information de sous-bande de mesure des signaux reçus, de la fréquence, du niveau des signaux détectés, une analyse spectrale numérique (de sigle ASN) dans la ou les sous-bandes de fréquences surveillées.

Le récepteur de la figure 1 comporte en outre, p voies de mesures V1, V2,...Vi,...Vp des signaux radiofréquences reçus. Chaque voie de mesures Vi, connectée par une entrée de voie de mesures Vmg1, Vmg2,...Vmgi,...Vmgp à une respective antenne de réception radiofréquences de mesures AM1, AM2,...AMi,...AMp, comporte n canaux de réception CR1, CR2, CRj,...CRn, p et n étant un nombre égal ou supérieur à 1, un récepteur RMC, R1, R2,...Rj,...Rp de mesures complètes du signal reçu.

Chaque canal de réception d'une voie de mesures Vi comporte une entrée radiofréquence Ec, une sortie Sc de signaux reçus numérisés, une respective entrée de commande Cm1, Cm2,..Cmj,...Cmn pour être piloté en fréquence et en sensibilité d'entrée radiofréquence par les signaux de désignation Sd1, Sd2,...Sdi,....Sdp en sortie de la voie de détection rapide VR.

A cet effet chaque canal de réception CRj d'une voie Vi comporte un convertisseur RF/FI 42 attaqué à une entrée d'oscillateur local par une fréquence locale générée par un respectif oscillateur local OLm 44 agile et commandable en fréquence par les respectifs signaux de désignation Sd1, Sd2,...Sdi,....Sdp en sortie du récepteur des mesures partielles RMP.

Le signal en fréquence intermédiaire FI en sortie du convertisseur RF/FI de chaque canal de réception CRj est filtré par un passe bande PB 46 de largeur de bande Bmj (correspondant à la sous-bande de mesure du récepteur CRj) puis numérisé par un convertisseur analogique numérique CAN 48 du canal de réception CRj fournissant le signal reçu numérisé dont la fréquence est désignée par le récepteur des mesures partielle RMP de la voie rapide VR.

La bande passante Bmj du filtre passe bande PB 46 des canaux de réception des voies de mesures est potentiellement inférieure à la bande passante Br du récepteur RBR de la voie rapide (Bmj<Br).

Les entrées radiofréquences Ec des n canaux de chacune des voies de mesures V1, V2,...Vi,...Vp sont connectées ensemble, par l'intermédiaire d'une ligne à retard Lr1, Lr2,...Lri,...Lrp, à une respective antenne de réception AM1, AM2,...AMi,...AMp de mesures. Chaque antenne de réception de mesures des voies de mesures est destinée à recevoir des signaux à détecter dans un respectif secteur angulaire θ1, θ2,..θi,..θp de l'espace, éventuellement dans certaines applications le même pour toutes les antennes.

Le récepteur RMC Ri par voie de mesure Vi fournit, à partir des respectifs signaux reçus numérisé en sorties des canaux de réception CR1, CR2, CRj,...CRn, des mesures complètes du signal reçu dans le secteur angulaire θi de l'espace couvert par l'antenne de réception de mesures correspondante AMi de la voie de mesures Vi et dans les n sous-bandes de mesure des récepteurs de largeurs Bm1, ..., Bmj,... Bmn autour des n fréquences désignées.

Les p voies de mesures assurent, de façon connue, la détection, par goniométrie, de la direction du signal radiofréquence reçu par le récepteur de surveillance selon l'invention.

Le récepteur peut être équipé d'une ou plusieurs voies de mesures. Lorsque le récepteur comporte plusieurs voies de mesures pour surveiller la totalité de l'espace, chacune des antennes de réception AM1, AM2,...AMi,...AMp de mesures présente un angle d'ouverture de son lobe principal tel que la somme des angles d'ouverture desdites antennes couvrent la totalité des 360°.

Dans une variante du récepteur à balayage rapide selon l'invention, la bande passante Bm1, ..., Bmj,... Bmn du filtre FI 46 de chaque canal de réception CR1, CR2, CRj,...CRn, est de largeur variable pour être adaptée à la largeur du signal reçu.

En effet le signal reçu peut comporter dans certains cas un ensemble de signaux très proches en fréquence (raies spectrales). Une adaptation de la bande passante du filtre FI à la largeur du spectre du signal reçu permet d'améliorer la qualité des mesures dans le canal de réception.

A cet effet le récepteur de mesures partielles RMP 22 de la voie rapide fournit des signaux de désignation Sd1, Sd2, ..Sdi,...Sdp comportant, outre une fréquence centrale du signal reçu, une information de largeur de bande de mesure transmise au canal de réception considéré.

Le filtre FI des canaux de réception sont alors réalisés pour être commandes en largeur de bande passante FI selon des techniques connues.

Par la suite est expliqué le principe de fonctionnement du récepteur de la figure 1 selon l'invention sous la forme d'un procédé pour la mise en oeuvre dudit récepteur.

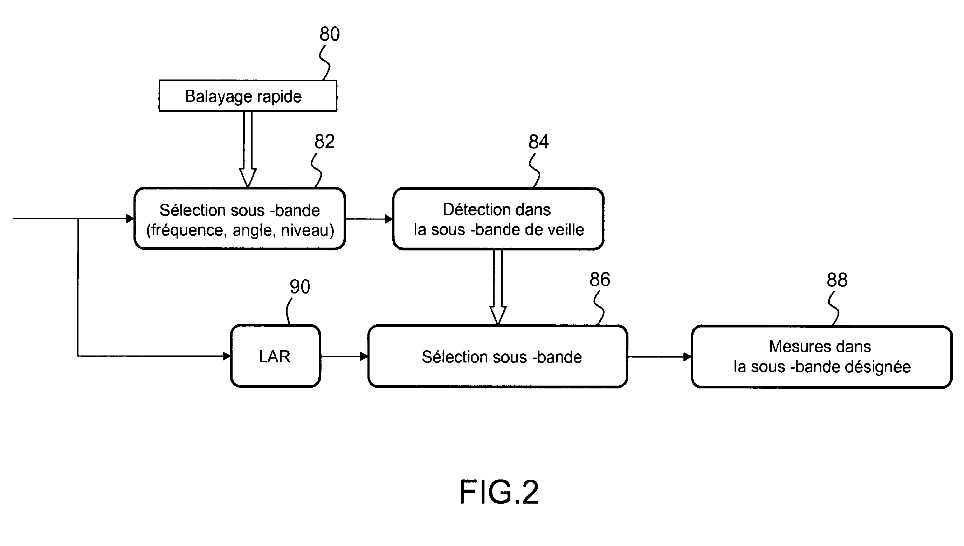

La figure 2 montre un schéma synoptique de principe d'un procédé de mise en oeuvre du récepteur de la figure 1.

L'acquisition du signal radiofréquence reçu de type impulsionnel se fait en au moins deux temps :
- dans un premier temps, la voie de détection rapide VR avertit de la présence d'un signal radiofréquence. A cet effet la voie rapide VR effectue un balayage rapide 80 de la bande de fréquence à surveiller par sélection de la sous-bande de fréquences, sélection de l'angle de surveillance et sélection du niveau du signal 82, puis détection 84 dans la sous-bande de surveillance (ou de veille). La détection du signal est réalisée sans effectuer toutes les mesures habituelles sur le signal reçu, dans ce cas sur l'impulsion.
- dans un deuxième temps, des mesures complètes du signal radiofréquence reçu sont effectuées avec précision par des voies de mesures V1, V2,...Vi,...Vp pilotées par la voie de détection rapide VR. Par exemple, les mesures effectuées par les récepteurs RMC de mesures compètes sont habituellement, la mesure précise de la fréquence, le niveau du signal reçu, le temps absolu ou relatif d'apparition de l'impulsion, la durée de l'impulsion, les caractéristiques des modulations dans l'impulsion (modulation intra pulse). A cet effet la voie de détection rapide VR commande la sélection de la sous-bande 86 puis les mesures dans la sous-bande désigné 88 par les voies de mesures V1, V2,...Vi,...Vp.

Une ligne à retard LAR 90 par voie de mesures retarde le signal reçu. Lorsque le signal reçu est une impulsion, la ligne à retard LAR de la voie de mesures retarde ladite impulsion reçue pour effectuer les mesures complètes sur la même impulsion détectée par la voie de détection rapide VR, y compris le front de montée de l'impulsion. La voie de mesures peut ainsi effectuer les mesures complètes sur la même impulsion détectée par la voie rapide VR mais qui arrivera avec un retard prédéterminé aux entrées des canaux de réception CR1, CR2, CRj,...CRn des respectives voies de mesures.

Lorsque 2 à n impulsions sont détectées simultanément par la voie rapide VR, les n récepteurs permettent de traiter toutes ces impulsions même si elles sont de fréquences très éloignées, 2 à n de ces récepteurs s'occupant chacun d'une de ces 2 à n impulsions.

Le signal reçu de type impulsionnel est détecté par le récepteur sur une fraction d'impulsion, avec une très bonne probabilité d'interception (POI).

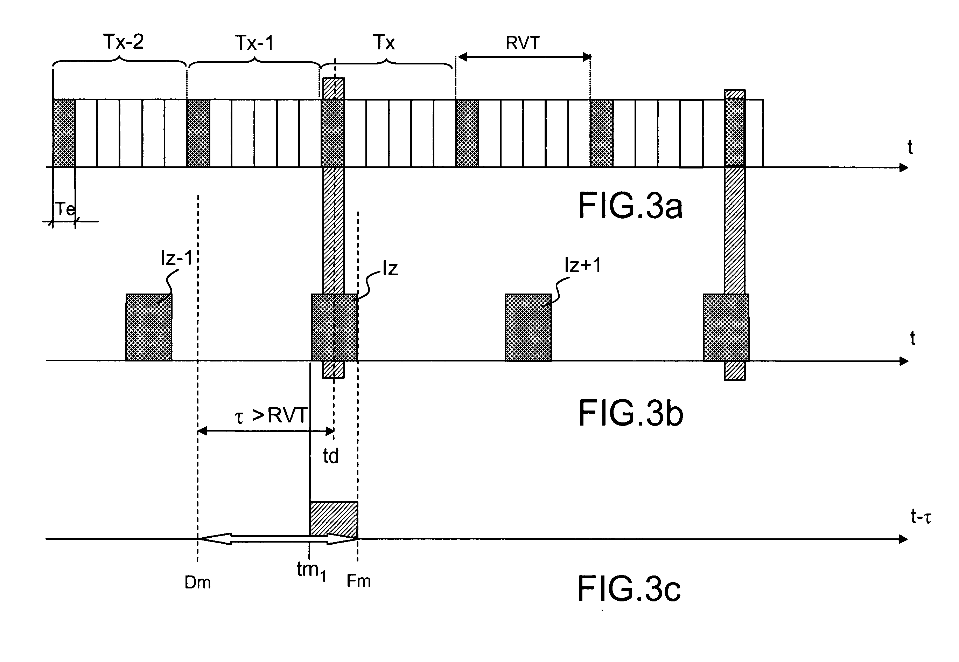

Les figures 3a, 3b et 3c montrent des diagrammes de détection d'un train d'impulsions radar par une suite de trames de veille du récepteur de la figure 1.

Le temps de balayage par la voie rapide VR de la bande de fréquences à surveiller résulte d'une suite de périodes d'écoute Te (ou durée d'écoute) dans une sous-bande Br de la bande de fréquences à surveiller. Cette suite de périodes d'écoute pour balayer la bande forme une trame Tx.

La durée d'écoute Te résulte notamment du temps minimum nécessaire pour commuter et détecter un signal radiofréquence reçu par la voie de détection rapide VR dans une sous-bande écoutée de largeur de fréquence Br.

La figure 3a montre une suite de trames Tx-2, Tx-1, Tx,....de veille du récepteur selon l'invention. Chaque trame Tx sur l'axe des temps t est formée, par une suite de périodes d'écoute Te de très faible durée, de l'ordre de grandeur de la plus courte durée d'impulsion émises par un émetteur NON COM.

La trame de durée RVT peut être de nature fréquentielle et angulaire. Dans le cas de la trame fréquentielle, chaque écoute de durée Te est effectuée pour une sous-bande de fréquences de largeur Br de la totalité de la bande de fréquences surveillée (ou de la sous-bande de fréquences). Par exemple la durée d'écoute est de 100ns, la durée de la trame balayant le domaine de fréquence surveillé peut être compris entre 1µs et 10µs.

De façon générale, la durée d'écoute de la voie de détection rapide VR est du même ordre de grandeur que la plus petite durée d'analyse spectrale des récepteurs de l'état de l'art à balayage lent, soit inférieure ou égale à 100ns.

La figure 3b montre un train d'impulsions émises par un radar dont seulement la suite d'impulsions Iz-1, Iz, Iz+1, Iz+2 est montrée sur la figure, sur le même axe des temps t.

Par exemple l'impulsion Iz, du train d'impulsions émise par le radar est détectée par le récepteur lors d'un période d'écoute Te de la trame Tx au temps de détection td. Dans ce cas la fréquence de l'impulsion Iz est dans une sous-bande d'écoute du récepteur à balayage rapide RBR de la voie rapide au moment où cette sous-bande est écoutée.

La voie de détection rapide VR transmet, lors de la détection de l'impulsion Iz, une information de sous-bande de fréquences et de niveaux du signal reçu détecté et éventuellement de direction d'arrivée du signal reçu à plusieurs voies de mesures Vi dont le lobe de leur antenne de réception est dirigé dans la direction du signal reçu.

Un canal de réception de la voie de mesures Vi, par exemple le premier canal de réception CR1 s'il s'agit d'une première impulsion détectée, est positionné à la fréquence de réception du signal radiofréquence détecté par les signaux de désignation en sortie du récepteur de mesures partielles RMP qui commande, par les entrée de commande Cm1, Cm2, Cmj,..Cmn des canaux de réception, la fréquence de l'oscillateur local OLm du canal de réception considéré Cmj.

Les canaux de réception suivants CM2, CMi.... effectuent la réception des impulsions radars suivantes ou éventuellement simultanées. Les signaux détectés et numérisés par les canaux de réception de chacune des voies de mesures V1, V2,...Vi,...Vp sont présentés aux respectives entrées des récepteurs des mesures complètes RMC fournissant les mesures complètes du signal reçu.

La figure 3c montre le début Dm et la fin Fm de la mesure de l'impulsion par le récepteur des mesures complètes RMC sur un axe de temps t-τ, étant le retard fixe apporté par la ligne à retard LAR de la voie de mesures Vi considérée. Ce retard τ est supérieur à la durée RVT de la trame pour pouvoir effectuer la mesure dès le début d'une impulsion qui ne serait détectée qu'en fin de trame.

Le retard τ apporté par les lignes à retard LAR a pour résultat que le début de la mesure Dm commandée par le récepteur de balayage rapide RMP de la voie rapide VR soit prêt à effectuer ses mesures avant que l'impulsion à mesurer Iz n'arrive sur le récepteur de mesures complètes RMC. Lorsque l'impulsion retardée arrive au temps tm1 sur l'axe t-τ, la mesure des paramètres de l'impulsion par le récepteur de mesures RMC commence et se poursuit sur toute la largeur de l'impulsion Iz reçue.

Dans cet exemple de réalisation, la durée d'écoute Te est de l'ordre de 100ns, pour des durées de trame variant entre 1µs et 10µs.

La durée d'écoute Te est définie comme étant le temps nécessaire à la voie rapide pour effectuer une détection d'un signal présent dans la sous-bande de largeur Br déterminée par le passe bande PB du récepteur à balayage rapide RBR de la bande de fréquence à surveiller.

Le temps de commutation de la voie rapide pour passer d'une bande de fréquences à une autre est inférieur à 50ns.

L'avantage d'un tel récepteur selon l'invention est qu'il garantit une probabilité d'interception POI d'un signal émis très élevée bien supérieure à celle des récepteurs lents de l'état de l'art. Cette POI ne dépend pratiquement plus de la période de répétition des impulsions reçues et de la durée de l'éclairement du récepteur par l'émetteur des impulsions.

Les impulsions émises par un émetteur sont détectables avec une probabilité proche de 1 au-delà d'une valeur limite de la durée d'une impulsion.

Dans une autre réalisation du récepteur selon l'invention, un balayage rapide en fréquence précède un balayage rapide de tout l'espace angulaire par commutation rapide du secteur angulaire.

La commutation du secteur angulaire peut, par exemple, être réalisée par commutation d'antennes mécaniques de mesures couvrant chacune un secteur angulaire déterminé, l'ensemble des antennes couvrant tout l'espace sur 360°, ou par une antenne à balayage électronique.

## Revendications

1. Récepteur radioélectrique de surveillance à balayage rapide du spectre électromagnétique dans une bande de fréquences comportant plusieurs sous-bandes de fréquences,
**caractérisé en ce qu'**il comporte :
- au moins une voie de détection rapide (VR) comportant un récepteur à balayage rapide RBR (20) de signaux radiofréquences dans au moins une des sous-bandes de fréquences, le récepteur à balayage rapide RBR étant connecté par une entrée (Er) à une antenne de réception radiofréquences (AR) de voie rapide et fournissant par une sortie (Sr) des signaux de réception de voie rapide, un récepteur de mesures partielles RMP (22) générant à partir des signaux de réception de voie rapide des signaux de désignation (Sd1, Sd2,...Sdi,...Sdp) d'une sous-bande de mesure du signal reçu, de la fréquence et du niveau des signaux détectés par la voie de détection rapide (VR) dans la sous-bande de fréquences écoutée (ou surveillée),
- p voies de mesures (V1, V2,...Vi,...Vp) des signaux reçus, p étant un nombre égal ou supérieur à 1, chaque voie de mesures étant connectée par une entrée de voie de mesures (Vmg1, Vmg2,...Vmgi,...Vmgp) par l'intermédiaire d'une ligne à retard LAR (Lr1, Lr2,...Lri,...Lrp) à une antenne de réception radiofréquences de mesures (AM1, AM2,...Ami,...AMp) destinée à recevoir des signaux à détecter dans un secteur angulaire (θ1, θ2,..θi,..θp) de l'espace, chaque voie de mesures (V1, V2,...Vi,...Vp) comportant n canaux de réception (CR1, CR2, CRj,...CRn), n étant un nombre égal ou supérieur à 1, chacun des canaux de réception fournissant des signaux de réception dans la sous-bande de mesure déterminée par les signaux de désignation (Sd1, Sd2,...Sdi,...Sdp) générés par la voie de détection rapide (VR), un récepteur RMC (R1, R2,...Ri,...Rp) par voie de mesures (V1, V2,...Vi,...Vp) fournissant, à partir des signaux de réception en sortie des n canaux de réception de la voie de mesures Vi considérée, des mesures complètes du signal radiofréquence reçu par le récepteur de surveillance.

2. Récepteur selon la revendication 1, **caractérisé en ce que** le récepteur à balayage rapide RBR (20) comporte un convertisseur RF/FI (23) de la fréquence d'entrée RF en fréquence intermédiaire FI fixe, un oscillateur Olr (24) commandé en fréquence attaquant le convertisseur RF/FI (23) pour balayer les sous-bandes de la bande de fréquences de réception de la voie rapide (VR), un filtre passe bande PB (26), de bande passante Br, de la fréquence intermédiaire FI, un convertisseur analogique numérique CAN (28) pour fournir à une sortie (Sr) du récepteur à balayage rapide RBR un signal radiofréquence reçu numérisé.

3. Récepteur selon l'une des revendications 1 ou 2, **caractérisé en ce que** chaque canal de réception (CR1, CR2, CRj,...CRn) comporte un convertisseur RF/FI (42) de la fréquence d'entrée RF de la voie de mesures en fréquence intermédiaire FI fixe, un oscillateur OLm (44) commandé en fréquence attaquant le convertisseur RF/FI (42) pour détecter le signal reçu désigné par la voie de détection rapide, un filtre passe bande PB (46), de bande passante Bm, en fréquence intermédiaire FI et un convertisseur analogique numérique CAN (48) pour fournir en sortie du canal de réception de la voie de mesures un signal radiofréquence reçu numérisé.

4. Récepteur selon l'une des revendications 1 à 3, **caractérisé en ce que** les signaux de désignation (Sd1, Sd2,...Sdi,...Sdp) générés par le récepteur à balayage rapide fournissent à chacun des canaux de réception (CR1, CR2, CRj,...CRn) une information de largeur de bande (Bm1, Bm2,...Bmj,...Bmn) de mesure des signaux reçus.

5. Récepteur selon l'une des revendications 3 ou 4, **caractérisé en ce que** la bande passante (Bm1, Bm2,...Bmj,...Bmn) du filtre FI (46) de chaque canal de réception est programmable par son respectif signal de désignation fournit par le récepteur de mesures partielles RMP (22) de la voie de détection rapide.

6. Récepteur selon l'une des revendications 2 à 5, **caractérisé en ce que** la bande passante du filtre passe bande PB (26) du récepteur RBR (20) de la voie de détection rapide est de la largeur des sous-bandes de fréquences.

7. Récepteur selon l'une des revendications 1 à 6, **caractérisé en ce que** les mesures complètes sur le signal radiofréquence reçu comportent au moins la fréquence, le niveau du signal, un temps absolu ou relatif d'arrivée du signal radiofréquence au récepteur.

8. Récepteur selon l'une des revendications 1 à 7, **caractérisé en ce que** lorsque le signal reçu est une suite d'impulsions radar, les mesures complètes sur l'impulsion émise comportent au moins la date d'arrivée du front montant et celle du front descendant, la durée et les caractéristiques de la modulation.

9. Récepteur selon l'une des revendications 1 à 8, **caractérisé en ce que** le temps de balayage de la bande de fréquence à surveiller étant formée par une suite de périodes d'écoute, une durée d'écoute (Te) de la voie de détection rapide est de l'ordre de grandeur de la plus courte durée d'impulsion (Iz) émise par un émetteur, soit inférieure ou égale à 100ns.

10. Récepteur selon l'une des revendications 1 à 9, **caractérisé en ce qu'**il permet la détection de signaux radioélectriques émis par des émetteurs non destinés à la transmission d'informations ou de type désigné par émetteur « NON COM » en langue anglaise.

11. Récepteur selon l'une des revendications 3 à 10, **caractérisé en ce que** la bande passante (Bm) du filtre passe bande PB (46) des canaux de réception des voies de mesures est inférieure à la bande passante (Br) du récepteur RBR de la voie rapide (Bm<Br).

12. Procédé de surveillance du spectre électromagnétique dans une bande de fréquences comportant plusieurs sous-bandes de fréquences par un récepteur radioélectrique selon l'une des revendications précédentes,
le récepteur comportant :
- au moins une voie de détection rapide (VR) comportant un récepteur à balayage rapide RBR (20) de signaux radiofréquences dans au moins un des sous-bandes de fréquences, le récepteur à balayage rapide RBR étant connecté par une entrée (Er) à une antenne de réception radiofréquences (AR) de voie rapide et fournissant par une sortie (Sr) des signaux de réception de voie rapide, un récepteur de mesures partielles RMP (22) générant à partir des signaux de réception de voie rapide des signaux de désignation (Sd1, Sd2,...Sdi,...Sdp) d'une sous-bande de mesure du signal reçu, de la fréquence et du niveau des signaux détectés par la voie de détection rapide (VR) dans la sous-bande de fréquences écoutée (ou surveillée),
- p voies de mesures (V1, V2,...Vi,...Vp) des signaux reçus, p étant un nombre égal ou supérieur à 1, chaque voie de mesures étant connectée par une entrée de voie de mesures (Vmg1, Vmg2,...Vmgi,...Vmgp) par l'intermédiaire d'une ligne à retard LAR (Lr1, Lr2,...Lri,...Lrp) à une antenne de réception radiofréquences de mesures (AM1, AM2,...Ami,...AMp) destinée à recevoir des signaux à détecter dans un secteur angulaire (θ1, θ2,..θi,..θp) de l'espace, chaque voie de mesures (V1, V2,...Vi,...Vp) comportant n canaux de réception (CR1, CR2, CRj,...CRn), n étant un nombre égal ou supérieur à 1, chacun des canaux de réception fournissant des signaux de réception dans la sous-bande de mesure déterminée par les signaux de désignation (Sd1, Sd2,...Sdi,...Sdp) générés par la voie de détection rapide (VR), un récepteur RMC (R1, R2,...Ri,...Rp) par voie de mesures (V1, V2,...Vi,...Vp) fournissant, à partir des signaux de réception en sortie des n canaux de réception de la voie de mesures Vi considérée, des mesures complètes du signal radiofréquence reçu par le récepteur de surveillance,
**caractérisé en ce qu'**il consiste :
- à effectuer, par la voie de détection rapide (VR), un balayage rapide en fréquence d'au moins une sous-bande de fréquences de la bande de fréquences à surveiller, une détection rapide des signaux radiofréquence reçus dans la sous-bande de fréquences considérée, la fourniture des signaux de désignation (Sd1, Sd2,...Sdi,...Sdp) pour piloter chaque voie de mesures,
- à commander en fréquence, par les signaux de désignation, la fréquence de réception des canaux de réception (CR1, CR2, CRj,...CRn) des voies de mesures,
- à effectuer des mesures complètes des signaux reçus par les voies de mesures en sortie des canaux de réception par les récepteurs de mesures complètes RMC (R1, R2,...Ri,...Rp).

13. Procédé de surveillance du spectre électromagnétique selon la revendication 12 **caractérisée en ce que** l'acquisition du signal radiofréquence reçu de type impulssionnel se fait en au moins deux temps :
- dans un premier temps, la voie de détection rapide (VR) avertit de la présence d'un signal radiofréquence en effectuant un balayage rapide (80) de la bande de fréquences à surveiller par sélection de la sous-bande de fréquences, de la fréquence, éventuellement par sélection de l'angle de surveillance et par sélection du niveau du signal (82), puis détection du signal (84) dans la sous-bande de surveillance (ou de veille),
- dans un deuxième temps, des mesures complètes du signal radiofréquence reçu sont effectuées avec précision par les voies de mesures V1, V2,...Vi,...Vp pilotées par la voie de détection rapide VR.

14. Procédé de surveillance du spectre électromagnétique selon l'une des revendications 12 ou 13, **caractérisée en ce que** les mesures effectuées par les récepteurs RMC de mesures compètes sont, la mesure précise de la fréquence, le niveau du signal reçu, le temps absolu ou relatif d'apparition de l'impulsion, la durée de l'impulsion, les caractéristiques des modulations dans l'impulsion (modulation intra pulse).

15. Procédé de surveillance du spectre électromagnétique selon l'une des revendications 12 à 14, **caractérisée en ce** le signal reçu étant une impulsion, la ligne à retard LAR de la voie de mesures retarde ladite impulsion reçue pour effectuer les mesures complètes sur la même impulsion détectée par la voie de détection rapide (VR).

16. Procédé de surveillance du spectre électromagnétique selon l'une des revendications 12 à 15, **caractérisé en ce que** le temps de balayage par la voie de détection rapide (VR) de la bande de fréquences à surveiller est formé par une suite de périodes d'écoute (Te) (ou durée d'écoute) dans une sous-bande(Br) de la bande de fréquences à surveiller.

17. Procédé de surveillance du spectre électromagnétique selon l'une des revendications 12 à 16, **caractérisé en ce que** la période d'écoute (Te) (ou durée d'écoute) est inférieure ou égale à 100ns.

18. Procédé de surveillance du spectre électromagnétique selon l'une des revendications 12 à 17, **caractérisé en ce que** les p voies de mesures assurent la détection, par goniométrie, de la direction du signal radiofréquence reçu par le récepteur de surveillance.

## Claims

1. Quick-scanning radio receiver for monitoring the electromagnetic spectrum in a frequency band comprising a plurality of frequency sub-bands,
**characterised in that** it comprises:
- at last one quick-detection path (VR) comprising a quick-scanning receiver RBR (20) for radiofrequency signals in at least one of the frequency sub-bands, the quick-scanning receiver RBR being connected via an input (Er) to a quick-path radiofrequency receiving aerial (AR) and providing via an output (Sr) quick-path reception signals, a partial measurement receiver RMP (22) generating, from quick-path reception signals, designation signals (Sd1, Sd2,...Sdi,...Sdp) of a sub-band for measuring the received signal, the frequency and the level of the signals detected by the quick-detection path (VR) in the listened-to (or monitored) frequencies sub-band,
- p measuring paths (V1, V2,...Vi,...Vp) for received signals, p being a number equal to or greater than 1, each measuring path being connected via a measuring path input (Vmg1, Vmg2,...Vmgi,...Vmgp) by means of a delay line LAR (Lr1, Lr2,...Lri,...Lrp) to a measuring radiofrequency receiving aerial (AM1, AM2,...Ami,...AMp) for receiving signals to be detected in an angular sector (θ1, θ2,...θi,...θp) of space, each measuring path (V1, V2,...Vi,...Vp) comprising n receiving channels (CR1, CR2, CRj,...CRn), n being a number equal to or greater than 1, each of the receiving channels providing reception signals in the measuring sub-band specified by the designation signals (Sd1, Sd2,...Sdi,...Sdp) generated by the quick-detection path (VR), a receiver RMC (R1, R2,...Ri,...Rp) providing via a measuring path (V1, V2,...Vi,...Vp), from reception signals output by the n receiving channels of the measuring path Vi in question, complete measurements of the radiofrequency signal received by the monitoring receiver.

2. Receiver according to claim 1, **characterised in that** the quick-scanning receiver RBR (20) comprises an RF/FI converter (23) for converting from the input frequency RF to the fixed intermediate frequency FI, a frequency-controlled oscillator Olr (24) driving the RF/FI converter (23) for scanning the sub-bands of the receiving frequency band of the quick path (VR), a band-pass filter PB (26), of bandwidth Br, of the intermediate frequency FI, an analogue-to-digital converter CAN (28) for providing a received digitised radiofrequency signal at an output (Sr) of the quick-scanning receiver RBR.

3. Receiver according to either claim 1 or claim 2, **characterised in that** each receiving channel (CR1, CR2, CRj,...CRn) comprises an RF/FI converter (42) for converting from the input frequency RF of the measuring path to a fixed intermediate frequency FI, a frequency-controlled oscillator OLm (44) driving the RF/FI converter (42) for detecting the received signal designated by the quick-detection path, a band-pass filter PB (46), of bandwidth Bm, at intermediate frequency FI and an analogue-to-digital converter CAN (48) for providing a received digitised radiofrequency signal at the output of the measuring path receiving channel.

4. Receiver according to any one of claims 1 to 3, **characterised in that** the designation signals (Sd1, Sd2,...Sdi,...Sdp) generated by the quick-scanning receiver provide each of the receiving channels (CR1, CR2, CRj,...CRn) with information on the bandwidth (Bm1, Bm2,...Bmj,...Bmn) for measuring the received signals.

5. Receiver according to either claim 3 or claim 4, **characterised in that** the bandwidth (Bm1, Bm2,...Bmi,...Bmn) of the PI filter (46) of each receiving channel is programmable by the respective designation signal thereof provided by the partial measurement receiver RMP (22) of the quick-detection path.

6. Receiver according to any one of claims 2 to 5, **characterised in that** the bandwidth of the band-pass filter PB (26) of the receiver RBR (20) of the quick-detection path is the width of the frequency sub-bands.

7. Receiver according to any one of claims 1 to 6, **characterised in that** the complete measurements on the received radiofrequency signal comprise at least the frequency, the signal level, an absolute or relative arrival time of the radiofrequency signal at the receiver.

8. Receiver according to any one of claims 1 to 7, **characterised in that**, when the received signal is a series of radar pulses, the complete measurements on the emitted pulse comprise at least the date of arrival of the leading edge and of the trailing edge, the duration and the modulation characteristics.

9. Receiver according to any one of claims 1 to 8, **characterised in that** the scanning time of the frequency band to be monitored is composed of a series of listening periods, a listening duration (Te) of the quick-detection path being in the order of magnitude of the shortest duration of a pulse (Iz) transmitted by a transmitter, i.e. less than or equal to 100 ns.

10. Receiver according to any one of claims 1 to 9, **characterised in that** it enables the detection of radio signals transmitted by transmitters not intended for transmitting information or of the type designated as a NON COM transmitter.

11. Receiver according to any one of claims 3 to 10, **characterised in that** the bandwidth (Bm) of the band-pass filter PB (46) of the receiving channels of the measuring paths is less than the bandwidth (Br) of the quick-path receiver RBR (Bm<Br).

12. Method for monitoring the electromagnetic spectrum in a frequency band comprising a plurality of frequency sub-bands by means of a radio receiver according to any one of the preceding claims,
the receiver comprising:
- at least one quick-detection path (VR) comprising a quick-scanning receiver RBR (20) for radiofrequency signals in at least one of the frequency sub-bands, the quick-scanning receiver RBR being connected via an input (Er) to a quick-path radiofrequency receiving aerial (AR) and providing via an output (Sr) quick-path reception signals, a partial measurement receiver RMP (22) generating, from quick-path reception signals, designation signals (Sd1, Sd2,...Sdi,...Sdp) of a sub-band for measuring the received signal, the frequency and the level of the signals detected by the quick-detection path (VR) in the listened-to (or monitored) frequencies sub-band,
- p measuring paths (V1, V2,...Vi,...Vp) for received signals, p being a number equal to or greater than 1, each measuring path being connected via a measuring path input (Vmg1, Vmg2,...Vmgi,...Vmgp) by means of a delay line LAR (Lr1, Lr2,...Lri,...Lrp) to a measuring radiofrequency receiving aerial (AM1, AM2,...Ami,...AMp) for receiving signals to be detected in an angular sector (81, θ2,...θi,...θp) of space, each measuring path (V1, V2,...Vi,...Vp) comprising n receiving channels (CR1, CR2, CRj,...CRn), n being a number equal to or greater than 1, each of the receiving channels providing reception signals in the measuring sub-band specified by the designation signals (Sd1 , Sd2,...Sdi,...Sdp) generated by the quick-detection path (VR), a receiver RMC (R1, R2,...Ri,...Rp) providing via a measuring path (V1, V2,...Vi,...Vp), from reception signals output by the n receiving channels of the measuring path Vi in question, complete measurements of the radiofrequency signal received by the monitoring receiver,
**characterised in that** it consists in:
- carrying out, via the quick-detection path (VR), quick frequency scanning of at least one frequency sub-band of the frequency band to be monitored, quick detection of the radiofrequency signals received in the frequency sub-band in question, providing designation signals (Sd1, Sd2,...Sdi,...Sdp) for controlling each measuring path,
- frequency-controlling, by means of the designation signals, the receiving frequency of the receiving channels (CR1, CR2, CRj,...CRn) of the measuring paths,
- carrying out complete measurements of the signals received by the measuring paths at the output of the receiving channels by means of the complete measurement receivers RMC (R1, R2,...Ri,...Rp).

13. Method for monitoring the electromagnetic spectrum according to claim 12, **characterised in that** the received pulse-type radiofrequency signal is acquired in at least two phases:
- in a first phase, the quick-detection path (VR) informs of the presence of a radiofrequency signal by carrying out quick scanning (80) of the frequency band to be monitored by selecting the frequency sub-band, the frequency, optionally by selecting the monitoring angle and by selecting the signal level (82), then detecting the signal (84) in the monitoring (or standby) sub-band,
- in a second phase, complete measurements of the received radiofrequency signal are carried out with precision by the measuring paths V1, V2,...Vi,...Vp controlled by the quick-detection path VR.

14. Method for monitoring the electromagnetic spectrum according to either claim 12 or claim 13, **characterised in that** the measurements carried out by the complete measurement receivers RMC are the precise measurement of the frequency, the level of the received signal, the absolute or relative time of occurrence of the pulse, the duration of the pulse, the characteristics of the modulations in the pulse (intra-pulse modulations).

15. Method for monitoring the electromagnetic spectrum according to any one of claims 12 to 14, **characterised in that** the received signal being a pulse, the delay line LAR of the measuring path delays said received pulse in order to carry out complete measurements on the same pulse detected by the quick-detection path (VR).

16. Method for monitoring the electromagnetic spectrum according to any one of claims 12 to 15, **characterised in that** the scanning time by the quick-detection path (VR) of the frequency band to be monitored is composed of a series of listening periods (Te) (or listening durations) in a sub-band (Br) of the frequency band to be monitored.

17. Method for monitoring the electromagnetic spectrum according to any one of claims 12 to 16, **characterised in that** the listening period (Te) (or listening duration) is less than or equal to 100 ns.

18. Method for monitoring the electromagnetic spectrum according to any one of claims 12 to 17, **characterised in that** the p measurement paths detect, by goniometry, the direction of the radiofrequency signal received by the monitoring receiver.

## Patentansprüche

1. Radioelektrischer Empfänger mit Schnellabtastung zur Überwachung des elektromagnetischen Spektrums in einem Frequenzband, das mehrere Frequenzsubbänder enthält,
**dadurch gekennzeichnet, dass** er Folgendes umfasst:
- wenigstens eine Schnellerkennungsstrecke (VR) mit einem Schnellabtastempfänger RBR (20) für Radiofrequenzsignale in wenigstens einem der Frequenzsubbänder, wobei der Schnellabtastempfänger RBR über einen Eingang (Er) mit einer Hochgeschwindigkeits-Radiofrequenzempfangsantenne (AR) verbunden ist und über einen Ausgang (Sr) Hochgeschwindigkeits-Empfangssignale liefert, wobei ein Teilmessempfänger RMP (22) von den Hochgeschwindigkeits-Empfangssignalen Bezeichnungssignale (Sd1, Sd2, ... Sdi, ... Sdp) eines Messsubbandes des empfangenen Signals mit der Frequenz und dem Pegel der Signale erzeugt, die von der Schnellerkennungsstrecke (VR) in dem abgehörten (oder überwachten) Frequenzsubband erkannt werden,
- p Messstrecken (V1, V2, ... Vi, ... Vp) für empfangene Signale, wobei p eine Zahl gleich oder größer als 1 ist, wobei jede Messstrecke über einen Messstreckeneingang (Vmg1, Vmg2, ... Vmgi, ... Vmgp) mittels einer Verzögerungsleitung LAR (Lr1, Lr2, ... Lri, ... Lrp) mit einer Messradiofrequenz-Empfangsantenne (AM1, AM2, ... Ami, ... AMp) zum Empfangen von Signalen verbunden ist, die in einem Winkelsektor θ1, θ2, ...θi, ... θp) des Raums erkannt werden sollen, wobei jede Messstrecke (V1, V2, ... Vi, ... Vp) n Empfangskanäle (CR1, CR2, CRj, ... CRn) umfasst, wobei n eine Zahl gleich oder größer als 1 ist, wobei jeder der Empfangskanäle Empfangssignale in dem Messsubband liefert, das von den Bezeichnungssignalen (Sd1, Sd2, ... Sdi, ... Sdp) bestimmt wird, die durch die Schnellerkennungsstrecke (VR) erzeugt werden, wobei ein Empfänger RMC (R1, R2, ... Ri, ... Rp) pro Messstrecke (V1, V2, ... Vi, ... Vp) von den Empfangssignalen am Ausgang der n Empfangskanäle der betrachteten Messstrecke Vi Vollmesswerte des von dem Überwachungsempfänger empfangenen Radiofrequenzsignals liefert.

2. Empfänger nach Anspruch 1, **dadurch gekennzeichnet, dass** der Schnellabtastempfänger RBR (20) Folgendes umfasst: einen RF/IF-Wandler (23) der RF-Eingangsfrequenz in eine feste Zwischenfrequenz IF, einen frequenzgesteuerten Oszillator Olr (24), der am RF/IF-Wandler (23) angreift, um die Subbänder des Empfangsfrequenzbandes der Schnellstrecke (VR) abzutasten, ein Bandpassfilter PB (26), mit dem Durchlassband Br, der Zwischenfreqenz IF, einen A/D-Wandler CAN (28) zum Anlegen eines empfangenen digitalisierten Radiofrequenzsignals an einen Ausgang (Sr) des Schnellabtastempfängers RBR.

3. Empfänger nach Anspruch 1 oder 2, **dadurch gekennzeichnet, dass** jeder Empfangskanal (CR1, CR2, CRj, ... CRn) Folgendes umfasst: einen RF/IF-Wandler (42) der RF-Eingangsfrequenz der Messstrecke in eine feste Zwischenfrequenz IF, einen frequenzgesteuerten Oszillator OLm (44), der den RF/IF-Wandler (42) angreift, um das von der Schnellerkennungsstrecke bezeichnete empfangene Signal zu erkennen, ein Bandpassfilter PB (46), mit dem Durchlassband Bm, der Zwischenfrequenz IF und einen A/D-Wandler CAN (48) zum Anlegen eines empfangenen digitialisierten Radiofrequenzsignals an den Ausgang des Empfangskanals der Messstrecke.

4. Empfänger nach einem der Ansprüche 1 bis 3, **dadurch gekennzeichnet, dass** die vom Schnellabtastempfänger erzeugten Bezeichnungssignale (Sd1, Sd2, ... Sdi, ... Sdp) jedem der Empfangskanäle (CR1, CR2, CRj, ... CRn) eine Messbandbreiteninformation (Bm1, Bm2, ... Bmj, ... Bmn) der empfangenen Signale liefern.

5. Empfänger nach Anspruch 3 oder 4, **dadurch gekennzeichnet, dass** das Durchlassband (Bm1, Bm2, ... Bmj, ... Bmn) des IF-Filters (46) jedes Empfangskanals durch sein jeweiliges Bezeichnungssignal programmiert werden kann, das vom Teilmessempfänger RMP (22) der Schnellerkennungsstrecke geliefert wird.

6. Empfänger nach einem der Ansprüche 2 bis 5, **dadurch gekennzeichnet, dass** das Durchlassband des Bandpassfilters PB (26) des Empfängers RBR (20) der Schnellerkennungsstrecke die Breite der Frequenzsubbänder hat.

7. Empfänger nach einem der Ansprüche 1 bis 6, **dadurch gekennzeichnet, dass** die Vollmessungen an dem empfangenen Radiofrequenzsignal wenigstens die Frequenz, den Pegel des Signals, eine absolute oder relative Ankunftszeit des Radiofrequenzsignals am Empfänger umfassen.

8. Empfänger nach einem der Ansprüche 1 bis 7, **dadurch gekennzeichnet, dass**, da das empfangene Signal eine Radarimpulsfolge ist, die Vollmessungen an dem emittierten Impuls wenigstens das Ankunftsdatum der ansteigenden Flanke und das der abfallenden Flanke, die Dauer und die Kennwerte der Modulation umfassen.

9. Empfänger nach einem der Ansprüche 1 bis 8, **dadurch gekennzeichnet, dass** die Abtastzeit des zu überwachenden Frequenzbandes von einer Folge von Abhörperioden gebildet wird, wobei eine Abhördauer (Te) der Schnellerkennungsstrecke in der Größenordnung der kürzesten Impulsdauer (1z) ist, die von einem Emitter emittiert wird, nämlich gleich oder kleiner als 100 ns.

10. Empfänger nach einem der Ansprüche 1 bis 9, **dadurch gekennzeichnet, dass** er die Erkennung von radioelektrischen Signalen durch Empfänger zulässt, die nicht für die Übertragung von Informationen bestimmt oder von dem Typ sind, der vom Emitter auf Englisch als "NON COM" bezeichnet wird.

11. Empfänger nach einem der Ansprüche 3 bis 10, **dadurch gekennzeichnet, dass** das Durchlassband (Bm) des Bandpassfilters PB (46) der Empfangskanäle der Messstrecken kleiner ist als das Durchlassband (Br) des Empfängers RBR der Schnellstrecke (Bm<Br).

12. Verfahren zum Überwachen des elektromagnetischen Spektrums in einem Frequenzband, das mehrere Frequenzsubbänder umfasst, durch einen radioelektrischen Empfänger nach einem der vorherigen Ansprüche,
wobei der Empfänger Folgendes umfasst:
- wenigstens eine Schnellerkennungsstrecke (VR) mit einem Schnellabtastempfänger RBR (20) für Radiofrequenzsignale in wenigstens einem der Frequenzsubbänder, wobei der Schnellabtastempfänger RBR über einen Eingang (Er) mit einer Hochgeschwindigkeits-Radiofrequenzempfangsantenne (AR) verbunden ist und über einen Ausgang (Sr) Hochgeschwindigkeits-Empfangssignale liefert, wobei ein Teilmessempfänger RMP (22) von den Hochgeschwindigkeits-Empfangssignalen Bezeichnungssignale (Sd1, Sd2, ... Sdi, ... Sdp) eines Messsubbandes des empfangenen Signals mit der Frequenz und dem Pegel der Signale erzeugt, die von der Schnellerkennungsstrecke (VR) in dem abgehörten (oder überwachten) Frequenzsubband erkannt werden,
- p Messstrecken (V1, V2, ... Vi, ... Vp) für empfangene Signale, wobei p eine Zahl gleich oder größer als 1 ist, wobei jede Messstrecke über einen Messstreckeneingang (Vmg1, Vmg2, ... Vmgi, ... Vmgp) mittels einer Verzögerungsleitung LAR (Lr1, Lr2, ... Lri, ... Lrp) mit einer Messradiofrequenz-Empfangsantenne (AM1, AM2, ... Ami, ... AMp) zum Empfangen von Signalen verbunden ist, die in einem Winkelsektor (θ1, θ2, ...θi, ... θp) des Raums erkannt werden sollen, wobei jede Messstrecke (V1, V2, ... Vi, ... Vp) n Empfangskanäle (CR1, CR2, CRj, ... CRn) umfasst, wobei n eine Zahl gleich oder größer als 1 ist, wobei jeder der Empfangskanäle Empfangssignale in dem Messsubband liefert, das von den Bezeichnungssignalen (Sd1, Sd2, ... Sdi, ... Sdp) bestimmt wird, die durch die Schnellerkennungsstrecke (VR) erzeugt werden, wobei ein Empfänger RMC (R1, R2, ... Ri, ... Rp) pro Messstrecke (V1, V2, ... Vi, ... Vp) von den Empfangssignalen am Ausgang der n Empfangskanäle der betrachteten Messstrecke Vi Vollmesswerte des von dem Überwachungsempfänger empfangenen Radiofrequenzsignals liefert,
**dadurch gekennzeichnet, dass** es Folgendes beinhaltet:
- Durchführen, über die Schnellerkennungsstrecke (VR), einer Frequenzschnellabtastung von wenigstens einem Frequenzsubband des zu überwachenden Frequenzbandes, einer Schnellerkennung der in dem betrachteten Frequenzsubband empfangenen Radiofrequenzsignale, des Lieferns von Bezeichnungssignalen (Sd1, Sd2, ... Sdi, ... Sdp) zum Steuern jeder Messstrecke,
- Frequenzsteuern, über die Bezeichnungssignale, der Empfangsfrequenz der Empfangskanäle (CR1, CR2, CRj, ... CRn) der Messstrecken,
- Durchführen von Vollmessungen an den empfangenen Signalen über die Messstrecken am Ausgang der Empfangskanäle durch die Vollmessungsempfänger RMC (R1, R2, ... Ri, ... Rp).

13. Verfahren zum Überwachen des elektromagnetischen Spektrums nach Anspruch 12, **dadurch gekennzeichnet, dass** die Erfassung des empfangenen Radiofrequenzssignals des Impulstyps zu wenigstens zwei Zeitpunkten erfolgt:
- zu einem ersten Zeitpunkt meldet die Schnellerkennungsstrecke (VR) die Anwesenheit eines Radiofrequenzsignals unter Durchführung einer Schnellabtastung (80) des zu überwachenden Frequenzbandes durch Auswählen des Frequenzsubbandes der Frequenz, eventuell durch Auswählen des Überwachungswinkels und durch Auswählen des Pegels des Signals (82), dann Erkennen des Signals (84) in dem überwachten (oder in Bereitschaft stehenden) Subband,
- zu einem zweiten Zeitpunkt werden die Vollmessungen des empfangenen Radiofrequenzsignals präzise durch die Messstrecken V1, V2, ... Vi, ... Vp durchgeführt, die von der Schnellerkennungsstrecke VR gesteuert werden.

14. Verfahren zum Überwachen des elektromagnetischen Spektrums nach Anspruch 12 oder 13, **dadurch gekennzeichnet, dass** die von den Vollmessempfängern RMC durchgeführten Messungen die genaue Messung der Frequenz, der Pegel des empfangenen Signals, des absoluten oder relativen Auftretenszeitpunkts des Impulses, der Dauer des Impulses, der Modulationskennlinien in dem Impuls (Intraimpulsmodulation) sind.

15. Verfahren zum Überwachen des elektromagnetischen Spektrums nach einem der Ansprüche 12 bis 14, **dadurch gekennzeichnet, dass** das empfangene Signal ein Impuls ist, wobei die Verzögerungsleitung LAR der Messstrecke den empfangenen Impuls verzögert, um die Vollmessungen an demselben Impuls durchzuführen, der von der Schnellerkennungsstrecke (VR) erkannt wurde.

16. Verfahren zum Überwachen des elektromagnetischen Spektrums nach einem der Ansprüche 12 bis 15, **dadurch gekennzeichnet, dass** der Zeitpunkt der Abtastung des zu überwachenden Frequenzbandes durch die Schnellerkennungsstrecke (VR) von einer Folge von Abhörperioden (Te) (oder Abhördauern) in einem Subband (Br) des zu überwachenden Frequenzbandes gebildet wird.

17. Verfahren zum Überwachen des elektromagnetischen Spektrums nach einem der Ansprüche 12 bis 16, **dadurch gekennzeichnet, dass** die Abhörperiode (Te) (oder die Abhördauer) gleich oder kleiner als 100 ns ist.

18. Verfahren zum Überwachen des elektromagnetischen Spektrums nach einem der Ansprüche 12 bis 17, **dadurch gekennzeichnet, dass** die p Messstrecken die Erkennung, durch Goniometrie, der Richtung des empfangenen Radiofrequenzsignals durch den Überwachungsempfänger gewährleistet.
